**Europäisches Patentamt**

**European Patent Office**

**Office européen des brevets**

(19)

(11) Veröffentlichungsnummer: **0 158 180**
**B1**

(12) # EUROPÄISCHE PATENTSCHRIFT

(45) Veröffentlichungstag der Patentschrift:
**03.06.87**

(51) Int. Cl.⁴: **C 30 B 15/00,** C 30 B 15/06

(21) Anmeldenummer: **85103256.5**

(22) Anmeldetag: **20.03.85**

(54) **Verfahren zum Herstellen von grossflóchigen Siliziumkristallkrpern fòr Solarzellen.**

(30) Priorität: **09.04.84 DE 3413369**

(43) Veröffentlichungstag der Anmeldung:
**16.10.85 Patentblatt 85/42**

(45) Bekanntmachung des Hinweises auf die Patenterteilung:
**03.06.87 Patentblatt 87/23**

(84) Benannte Vertragsstaaten:
**DE FR GB IT**

(56) Entgegenhaltungen:
**DE - A - 3 010 557**
**DE - A - 3 226 931**
**DE - A - 3 231 326**

(73) Patentinhaber: **Siemens Aktiengesellschaft Berlin und München, Wittelsbacherplatz 2, D-8000 München 2 (DE)**

(72) Erfinder: **Grabmaier, Josef, Dr., Am Seefeld 17, D-8137 Starnberg 1 (DE)**
Erfinder: **Falckenberg, Richard, Dr., Hofen 21, D-8952 Wald (DE)**

## Beschreibung

Die Erfindung betrifft ein Verfahren zum Herstellen von grossflächigen, quasi-monokristallinen Siliziumkristallkörpern für Solarzellen durch kontinuierliches Beschichten eines flächenförmigen, eine netzartige Struktur aufweisenden Trägerkörpers aus einem Carbonfasergewebe, bei dem das schmelzflüssige Silizium mit dem Trägerkörper in Kontakt gebracht wird und bei dem bei der Kristallisation des Siliziums der Trägerkörper in den Siliziumkörper integriert wird.

Ein solches Verfahren ist beispielsweise aus der DE-OS 3 010 557 A1 bekannt. Hier wird ein Verfahren zur Herstellung von Flächensilizium bei hohem Durchsatz (~ 1 m2/min) für Solarzellen beschrieben, bei dem die Beschichtung in bezug auf die Ziehgeschwindigkeit so geführt wird, dass sich aufgrund der hohen Oberflächenspannung des geschmolzenen Siliziums in den Maschen des Netzes eine dünne Siliziumschicht ausbildet, so dass nach dem Erstarren das aus den Fasern bestehende Netzwerk in den Siliziumkörper integriert ist. Bei der Beschichtung wird der Trägerkörper durch eine spaltförmige Öffnung im Boden einer Schmelzwanne gezogen. Der Trägerkörper kann aber auch tangierend über die Oberfläche der in einer Wanne befindlichen Siliziumschmelze gezogen werden, wie es beispielsweise aus der DE-OS 2 850 805 bekannt ist.

Das wegen seiner Temperaturbeständigkeit und mechanischen Flexibilität als Trägerkörper sehr gut geeignete Carbonfasergewebe hat den Nachteil, dass Kohlenstoff bei der Beschichtung mit Silizium in Lösung geht. Die Sättigungslöslichkeit von Kohlenstoff in der Silizium-Schmelze beträgt $10^{18}$ At/cm$^3$. Sobald nach einer kurzen Anlaufphase die Sättigung der Schmelze mit Kohlenstoff erreicht ist, wird Kohlenstoff in dieser Konzentration in das Siliziumband miteingebaut. Ein solcher Einbau führt zu einer Verringerung des Wirkungsgrades der aus diesem Material gefertigten Solarzelle um bis zu 3%.

Die Aufgabe, die der Erfindung zugrundeliegt, besteht deshalb darin, zu vermeiden, dass Kohlenstoff aus dem Carbonfasergewebe in Lösung geht.

Diese Aufgabe wird bei einem Verfahren der eingangs genannten Art dadurch gelöst, dass zur Vermeidung des Einbaus von Kohlenstoff in das kristallisierende Silizium der aus dem Carbonfasergewebe bestehende Trägerkörper zumindest an seiner Oberfläche unmittelbar vor der Beschichtung in Siliziumcarbid übergeführt wird.

Würde man gleich ein Siliziumcarbin-Fasergewebe als Trägerkörper verwenden, so hätte dies den Nachteil, dass es

1. wegen der Sprödigkeit von Siliziumcarbid schwierig herstellbar wäre und
2. beim Bandziehen häufig Faserbrüche auftreten; die abstehenden Faserenden führen dann zu Störungen im Kristallgitter, insbesondere an den pn-Übergängen.

Weitere Ausgestaltungen der Erfindung ergeben sich aus den Unteransprüchen.

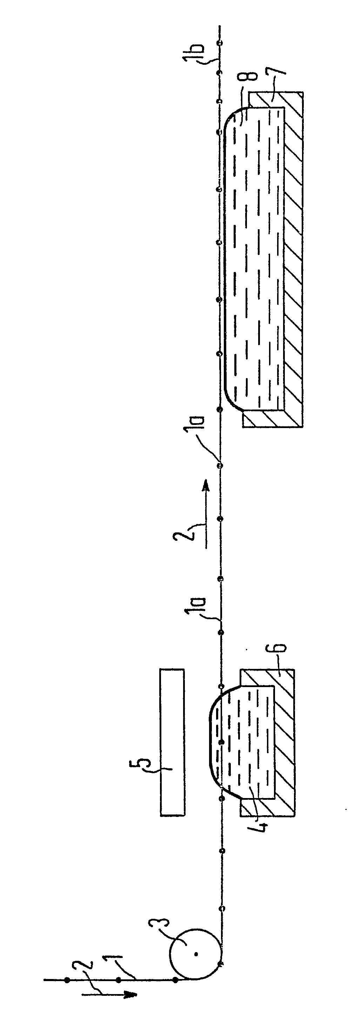

Weitere Einzelheiten, insbesondere über die Durchführung des erfindungsgemässen Verfahrens, werden im folgenden anhand eines Ausführungsbeispiels und der in der Zeichnung befindlichen Figur, welche schematisch eine Anordnung zur erfindungsgemässen Beschichtung darstellt, noch näher beschrieben.

Der aus dem Carbonfasergewebe bestehende Trägerkörper 1 wird in Pfeilrichtung 2 über eine Rolle 3 durch die Oberfläche eines Siliziumbades 4, welches sich in einer, von einem Heizer 5 bedeckten Schmelzwanne 6 befindet, gezogen und durch Reaktion des schmelzflüssigen Siliziums (4) mit dem Kohlenstoff in ein Siliziumcarbid-Fasergewebe 1a übergeführt. Das der eigentlichen Siliziumbeschichtung in der Schmelzwanne 7 vorgeschaltete Siliziumbad 4, 6 befindet sich dabei auf einer vorzugsweise 50°C über dem Schmelzpunkt von Silizium liegenden Temperatur. Dadurch wird eine vollständige Umwandlung der Carbonfasern (1) in Siliziumcarbid-Fasern (1a) erreicht. Eine Beschichtung des Trägerkörpers 1 mit Silizium unterbleibt hier wegen der bei der vorgeschlagenen Temperatur geringen Oberflächenspannung der Siliziumschmelze (4). Das Siliziumbad 4, 6 wird auf gleicher Höhe und unmittelbar vor der Beschichtungsvorrichtung 7, 8 angebracht, so dass eine mechanische Belastung des spröden Siliziumcarbidgewebes 1a nicht auftritt.

Die Zeitdauer für eine quantitative Umwandlung von Carbonfasern 1 (~ 1000 Filamente pro Strang = Roving) in Siliziumcarbid-Fasern 1a beträgt bei 1450°C etwa 30 Sekunden. Die Badlänge (4) muss daher mit der Ziehgeschwindigkeit des Gewebes (1, 1a, 1b) abgestimmt werden. So ist z.B. bei einer Ziehgeschwindigkeit von 10 cm/min eine Badlänge (4) von 0,35 cm und bei einer Ziehgeschwindigkeit von 2 m/min eine Badlänge (4) von etwa 7 cm erforderlich. Eine Verkürzung der Reaktionszeit durch weitere Erhöhung der Badtemperatur (4) ist nicht zweckmässig, da dann die Zugfestigkeit der Siliziumcarbid-Fasern 1a abnimmt.

Mit dem Bezugszeichen 1b ist das fertig beschichtete Siliziumband bezeichnet, welches nach Durchlaufen des Siliziumcarbidträgerkörpers 1a durch die Oberfläche der in der Schmelzwanne 7 befindlichen Siliziumschmelze 8 entsteht. Die Siliziumschmelze 8 und das Siliziumbad 4 wird laufend durch neues Material ergänzt (in der Figur nicht dargestellt).

Ein Vorteil des erfindungsgemässen Verfahrens liegt auch darin, dass in dem Silizierungsbad 4 Verunreinigungen aus dem Carbonfasernetz 1 herausgelöst werden können, bzw. im Gewebe 1 noch verbleibende Verunreinigungen dort «eingefroren» werden und so die Silizium-Beschichtungsschmelze 8 nicht verunreinigen können.

## Patentansprüche

1. Verfahren zum Herstellen von quasi-monokristallinen, grossflächigen Siliziumkristallkörpern für Solarzellen durch kontinuierliches Beschichten eines flächenförmigen, eine netzartige Struktur aufweisenden Trägerkörpers aus einem Carbonfasergewebe, bei dem das schmelzflüssige Silizium mit dem Trägerkörper in Kontakt gebracht wird und bei dem bei der Kristallisation des Siliziums der Trägerkörper in den Siliziumkörper integriert wird, dadurch gekennzeichnet, dass zur Vermeidung des Einbaus von Kohlenstoff in das kristallisierende Silizium (1b) der aus dem Carbonfasergewebe bestehende Trägerkörper (1) unmittelbar vor der Siliziumbeschichtung (7, 8) zumindest an seiner Oberfläche in Siliziumcarbid (1a) übergeführt wird.

2. Verfahren nach Anspruch 1, dadurch gekennzeichnet, dass der Trägerkörper (1) durch ein Siliziumbad (4) im Bereich von 1450 bis 1550°C gezogen wird.

3. Verfahren nach Anspruch 1 und/oder 2, dadurch gekennzeichnet, dass bei der Ziehgeschwindigkeit von 10 cm/min die Badlänge (4) auf 0,35 cm und bei einer Ziehgeschwindigkeit von 2 m/min die Badlänge (4) auf 7 cm eingestellt wird.

## Claims

1. A process for the production of quasi-monocrystalline silicon crystal bodies with large surfaces for solar cells by continuously coating a flat carrier body which has a reticular structure and consists of a carbon fibre fabric, wherein the molten silicon is brought into contact with the carrier body and the carrier body is integrated into the silicon body during the crystallization of the silicon, characterised in that, in order to avoid the incorporation of carbon into the crystallized silicon (1b), the carrier body (1) consisting of the carbon fibre fabric is at least at its surface converted into silicon carbide (1a) immediately prior to the coating with silicon (7, 8).

2. A process as claimed in Claim 1, characterised in that the carrier body (1) is drawn through a silicon bath (4) in the region of 1450 to 1500°C.

3. A process as claimed in Claim 1 and/or 2, characterised in that with a drawing speed of 10 cm/min, the bath length (4) is set at 0.35 cm, and with a drawing speed of 2 m/min, the bath length (4) is set at 7 cm.

## Revendications

1. Procédé de fabrication de corps quasi-monocristallins de grande surface en silicium cristallin, pour cellules solaires, par enduction continue d'un support plat, présentant une structure en forme de filet et constitué d'un tissu de fibres de carbone, selon lequel on met du silicium fondu en contact avec le support et selon lequel, à la cristallisation du silicium, on produit l'intégration du support dans le corps de silicium, caractérisé en ce que, pour éviter l'incorporation de carbone dans le silicium (1b) en cours de cristallisation, on transforme le support (1), en tissu de fibres de carbone, en carbure de silicium (1a), au moins à sa surface, immédiatement avant son enduction (7, 8).

2. Procédé selon la revendication 1, caractérisé en ce que l'on tire le support (1) à travers un bain de silicium (4) d'une température comprise entre 1450 et 1500°C.

3. Procédé selon la revendication 1 et/ou 2, caractérisé en ce que, pour une vitesse de tirage ou de défilement de 10 cm/min, on ajuste la longueur du bain (4) à 0,35 cm et, pour une vitesse de tirage de 2 m/min, on ajuste la longueur du bain (4) à 7 cm.

0 158 180